# EUROPÄISCHE PATENTSCHRIFT

(11) **EP 3 952 053 B1**
(45) Veröffentlichungstag und Bekanntmachung des Hinweises auf die Patenterteilung: **02.07.2025**
(21) Anmeldenummer: 21188132.1
(22) Anmeldetag: 28.07.2021
(51) Int. Cl.: H02J 7/00, B60L 58/22, B60L 58/18

(54) **VERFAHREN ZUM BETREIBEN EINES BATTERIESYSTEMS**
METHOD FOR OPERATING A BATTERY SYSTEM
PROCÉDÉ DE FONCTIONNEMENT D'UN SYSTÈME DE BATTERIE

(30) Priorität: 07.08.2020 DE 102020210046
(43) Veröffentlichungstag der Anmeldung: 09.02.2022
(73) Patentinhaber: Robert Bosch GmbH, 70442 Stuttgart (DE)
(72) Erfinder: Woll, Christoph, 70839 Gerlingen (DE); Handte, Gunther, 72669 Unterensingen (DE)

(56) Entgegenhaltungen:
- DE-A1- 102012 210 910

## Beschreibung

Die Erfindung betrifft ein Verfahren zum Betreiben eines Batteriesystems. Dabei umfasst das Batteriesystem mehrere parallel zueinander geschaltete Stränge, die jeweils mindestens ein Batteriemodul aufweisen. In dem mindestens einen Batteriemodul sind mehrere Batteriezellen in Serienschaltung und/oder in Parallelschaltung verschaltet. Dabei sind die einzelnen Stränge unabhängig voneinander zu- und abschaltbar. Dabei sind einzelnen Batteriezellen oder einzelnen Batteriezellenpakete, die jeweils mehrere parallel verschaltete Batteriezellen umfassen, unabhängig voneinander zu- und abschaltbar.

Die Erfindung betrifft ferner ein Batteriesystem, das eingerichtet ist, das erfindungsgemäß vorgeschlagene Verfahren durchzuführen.

Die Erfindung betrifft auch ein Fahrzeug, das eingerichtet ist, das erfindungsgemäß vorgeschlagene Verfahren durchzuführen und/oder das erfindungsgemäß vorgeschlagene Batteriesystem umfasst.

### Stand der Technik

In heutigen elektrisch angetriebenen Fahrzeugen sind mehrere Batteriezellen nicht nur seriell miteinander verschaltet, sondern auch auf parallele Weise. Dadurch wird eine ausreichend hohe Batteriekapazität und damit eine hohe Fahrzeugreichweite erzielt, aber auch die erforderliche Leistung kann somit zur Verfügung gestellt werden. Eine Parallelschaltung solcher Batteriezellen erfolgt meistens innerhalb eines Batteriemoduls, wobei mehrere Batteriemodule seriell miteinander verbunden werden, um die erforderliche Batteriespannung zu erreichen. Zu jedem Batteriemodul gehört eine Batteriezellüberwachungseinheit (Cell Supervising Circuit, CSC), welche die einzelnen Batteriezellenspannungen und die Temperatur(en) im Batteriemodul misst und an eine übergeordnete Batteriesteuereinheit (Battery Control Unit, BCU) zur weiteren Auswertung weiterleitet.

Für autonom betriebene elektrische Fahrzeuge (Electric Vehicle, EV) gelten besondere Anforderungen, insbesondere hinsichtlich der Fahrtüchtigkeit des Fahrzeugs, da ein Liegenbleiben solcher Fahrzeuge nicht zugelassen ist. Diese Fahrzeuge müssen je nach Automatisierungsgrad ein bestimmtes Sicherheitslevel (Safe-Stop-Level, SSL) erfüllen. Hierzu werden sie nach unterschiedlichen Risikostufen klassifiziert (Automotive Safety Integrity Level, ASIL), was mit erhöhten Anforderungen an das Batteriedesign verbunden ist. Weniger fehleranfällige Systeme oder gar fehlertolerante Systeme können eine Redundanz, d. h. eine Verdopplung, einzelner Teilkomponenten bis hin zur Verdopplung des gesamten Batteriesystems bedeuten.

Die Nachteile einer Redundanz, wie beispielsweise der Bauraum und insbesondere die Kosten, gelten vornehmlich für die teuerste Komponente des Antriebsstrangs, der Batterie. Erste Ansätze zielen in die Richtung die Batterien nicht nur einsträngig, d. h. einzelne Batteriezellen oder parallel verschaltete Batteriezellen sind alle seriell verschaltet, aufzubauen, sondern die Batterie aus zwei oder gar mehreren Batteriemodulen, welche parallel verschaltet sind, aufzubauen. Mehrere parallel verschaltete Batteriemodule bedeuten nur bedingt mehr Bauraum, da die Batteriezellen entsprechend ihrer Batteriekapazität halbiert oder gar geviertelt werden müssen.

Fällt fehlerbedingt eine Batteriezelle aus, so wird heute das Batteriemodul mit der fehlerhaften Batteriezelle abgeschaltet oder bei Fehlern in mehreren Modulen in einem Strang kann auch der komplette Strang abgeschaltet werden. Bei Batteriemodulen mit Kopplungseinrichtungen an den einzelnen Batteriezellen des Batteriemoduls kann im Fehlerfall die defekte Batteriezelle überbrückt werden. Bei einem solchen Batteriesystem bedeutet dies jedoch, dass auch jeweils eine intakte Batteriezelle aus allen weiteren Strängen des Batteriesystems überbrückt werden muss, um die gleiche Spannung in den Strängen zu erhalten. Gleiches gilt auch für Batteriesysteme mit parallel verschalteten Modulen; intakte Batteriezellen gehen dem Batteriesystem somit verloren.

Das Dokument US 2012/0091964 A1 offenbart eine Bypass-Schaltung für eine Batterie und insbesondere eine serielle Bypass-Schaltung für ein Fahrzeugbatteriesystem, die ein oder mehrere Batteriezellen oder Module in dem Batteriesystem in Reaktion auf einen Zell- oder Modulfehler oder einen potentiellen Zell- oder Modulfehler abschaltet und mittels eines Bypasses umgeht.

Das Dokument US 2016/0240894 A1 beschreibt ein Batteriemanagementsystem zum Überwachen und Regeln des Betriebs einer nachladbaren Batterie, welche eine Mehrzahl von elektrisch miteinander verschalteten, jeweils wenigstens eine Batteriezelle umfassenden Batteriemodulen aufweist, wobei das Batteriemanagementsystem wenigstens eine Steuergeräteeinheit und wenigstens eine Zellüberwachungseinheit umfasst, und wobei die wenigstens eine Zellüberwachungseinheit ausgebildet ist, Daten bezüglich wenigstens eines Betriebsparameters von wenigstens einer Batteriezelle zu empfangen, die empfangenen Daten zu erfassen und die erfassten Daten an die wenigstens eine Steuergeräteeinheit zu übertragen.

Das Dokument DE 10 2012 210 910 A1 offenbart ein Verfahren zum Betreiben eines elektrischen Traktionsantriebssystems mit Batteriedirektinverter und dazugehörige Steuerungsvorrichtung.

### Offenbarung der Erfindung

Es wird ein Verfahren zum Betreiben eines Batteriesystems für ein Fahrzeug, insbesondere ein Elektrofahrzeug, gemäß Anspruch 1 vorgeschlagen. Dabei umfasst das Batteriesystem mehrere parallel zueinander geschaltete Stränge, die jeweils mindestens ein Batteriemodul aufweist. In dem mindestens einen Batteriemodul sind mehrere Batteriezellen in Serienschaltung und/oder in Parallelschaltung verschaltet. Dabei sind die einzelnen Stränge unabhängig voneinander zu- und abschaltbar.

Vorzugsweise sind die einzelnen Batteriezellen unabhängig voneinander zu- und abschaltbar. Dabei umfasst das Batteriesystem innerhalb der einzelnen Batteriemodule erste Kopplungseinrichtungen, mit denen einzelne Batteriezellen innerhalb des Batteriemoduls abgeschaltet und über eine Umgehungsleitung, in der zweite Kopplungseinrichtungen aufgenommen sind, überbrückt werden können.

Vorteilhaft können die Batteriezellen zu mehreren Batteriezellenpaketen zusammengefasst werden, die jeweils mehrere parallel verschaltete Batteriezellen umfassen. Dabei umfasst das Batteriesystem innerhalb der einzelnen Batteriemodule erste Kopplungseinrichtungen, mit denen einzelne Batteriezellenpakete innerhalb des Batteriemoduls abgeschaltet und über eine Umgehungsleitung, in der zweite Kopplungseinrichtungen aufgenommen sind, überbrückt werden können.

Das Batteriesystem kann eine Batteriesteuereinheit zur Überwachung des mindestens einen Batteriemoduls und zur Ansteuerung der Hauptschalter und/oder der ersten sowie der zweiten Kopplungseinrichtung aufweisen. Das mindestens eine Batteriemodul kann eine Batteriezellenüberwachungseinheit mit Sensoren zur Erfassung von Messwerten der Batteriezellen sowie des mindestens einen Batteriemoduls aufweisen. Dabei kommuniziert die Batteriezellenüberwachungseinheit mit der Batteriesteuereinheit. Die Batteriesteuereinheit kann dabei eine Auswertungselektronik zum Auswerten der von den Sensoren erfassten Messwerte der Batteriezellen sowie des mindestens einen Batteriemoduls aufweisen.

Zu den von den Sensoren erfassten Messwerten gehören beispielsweise eine Temperatur und eine Spannung jeder einzelnen Batteriezelle sowie eine Temperatur und eine Spannung des gesamten Batteriemoduls.

Des Weiteren kann das Batteriesystem so ausgeführt werden, dass dieses erste Kopplungseinrichtungen aufweist, mit denen Batteriemodule aus dem Strang abgeschaltet und über Umgehungsleitungen, die zweite Kopplungseinrichtungen umfassen, überbrückbar sind.

Erfindungsgemäß wird zunächst ein Fehler einer Batteriezelle erkannt. Dies kann durch Auswertung der Messwerte erfolgen. Unter dem Fehler einer Batteriezelle wird ein Zellenfehler oder ein Elektronikfehler, welche an den der Batteriezelle zugeordneten elektronischen Teilen, wie beispielsweise einer Batterieüberwachungseinheit oder einem Sensor, auftritt, verstanden
Anschließend wird die fehlerhafte Batteriezelle oder des fehlerhaften Batteriepakets, in dem sich die fehlerhafte Batteriezelle befindet, abgeschaltet und überbrückt. Die fehlerhafte Batteriezelle oder das fehlerhafte Batteriezellenpaket bleibt dabei dauerhaft überbrückt.

Gleichzeitig wird der fehlerhafte Strang abgeschaltet, der die fehlerhafte Batteriezelle oder das fehlerhafte Batteriepaket aufweist.

Anschließend wird die Strangspannung des fehlerhaften Strangs mit der Strangspannung der jeweiligen intakten Stränge, bei denen keine Fehler erkannt wurden, verglichen.

Danach werden die intakten Stränge entladen, wenn Spannungsdifferenzen zwischen den Strängen einen Spannungsschwellenwert überschreiten. Der fehlerhafte Strang bleibt nur solange abgeschaltet, bis sich die Strangspannungen der intakten Stränge nahezu auf das Niveau des fehlerhaften Strangs angeglichen haben. Dabei stellen die intakten Stränge die Energie für das Elektrofahrzeug zur Verfügung und liefern entsprechend höhere Strangströme. Der fehlerhafte Strang wird weiterhin zugeschaltet, wenn ein Rekuperationsvorgang stattfindet. Die intakten Batteriezellen des fehlerhaften Strangs werden dabei durch den Rekuperationsstrom solange aufgeladen, bis eine Spannungsangleichung der Stränge erfolgt ist. Danach werden die intakten Batteriezellen aller Stränge aufgeladen.

Vorzugsweise wird der fehlerhafte Strang zugeschaltet, wenn
Spannungsdifferenzen zwischen den Strängen den Spannungsschwellenwert unterschreiten.

Auf gleichem Spannungsniveau stehen wieder alle Stränge zur Verfügung und können somit ihre maximale Leistung liefern bis eine Entladeschlussspannung erreicht ist. Der Energieverlust, welcher sich letztendlich auf die Reichweite niederschlägt, ergibt sich lediglich aus der Dauer einer Spannungsanpassungsphase und einem Entladestrom. Die führt vorteilhafter weise dazu, dass die Verfügbarkeit und Zuverlässigkeit der Traktionsversorgung gesteigert wird. Dadurch lassen sich beliebige Safe-Stop-Levels erreichen.

Vorzugsweise liegt der Spannungsschwellenwert in einem Bereich von 1 V bis 2 V. Dadurch können batterieschädigende Ausgleichsströme verhindert werden.

Die Fahrt kann somit ohne Einschränkungen fortgeführt werden; eine Reparatur kann danach erfolgen. Findet kein Batteriezellen- oder Batteriemodultausch statt und wird die Batterie des Elektrofahrzeugs geladen, so können vorzugsweise alle Stränge beim Laden des Batteriesystems aufgeladen werden. Dabei wird ein Ladevorgang beim Erreichen einer um eine oder mehrere Zellenspannungen reduzierte Strangspannung beendet.

Alternativ können zunächst die intakten Stränge beim Laden des Batteriesystems mit dem abgeschalteten fehlerhaften Strang vollständig aufgeladen werden. Nach dem vollständigen Laden erfolgt ein Entladevorgang der intakten Stränge, bis sich die Strangspannungen aller Stränge auf gleichem Niveau befinden.

Vorzugsweise wird der fehlerhafte Strang beim Erkennen von Elektronikfehlern erst abgeschaltet, wenn ein Strangstrom des fehlerhaften Strangs einen Stromschwellenwert unterschreitet. Vorzugsweise liegt der Stromschwellenwert in einem Bereich von 15 A bis 25 A.

Darüber hinaus kann das erfindungsgemäß vorgeschlagene Verfahren so durchgeführt werden, dass beim Erkennen von Batteriefehlern und/oder Batteriemodulfehlern ein Batteriemodul abgeschaltet wird.

Ferner wird ein Batteriesystem vorgeschlagen, das eingerichtet ist, das erfindungsgemäß vorgeschlagene Verfahren durchzuführen.

Es wird auch ein Fahrzeug vorgeschlagen, das eingerichtet ist, das erfindungsgemäß vorgeschlagene Verfahren durchzuführen und/oder das das erfindungsgemäß vorgeschlagene Batteriesystem umfasst.

### Vorteile der Erfindung

Mit dem erfindungsgemäß vorgeschlagenen Verfahren kann ein Batteriesystem kosten- und bauraumgünstig bei gleichzeitiger maximal möglicher Kapazität im Fehlerfall betrieben werden kann. Die Umsetzung des erfindungsgemäß vorgeschlagenen Verfahrens basiert rein softwaretechnisch und somit ist keine zusätzliche Hardware, wie beispielsweise Elektronik für das Batteriesystem, erforderlich.

Dabei ist kein redundantes Batteriemodul für das Batteriesystem erforderlich. Durch das erfindungsgemäß vorgeschlagene Verfahren werden die Spannung der intakten Batteriemodule bzw. Stränge an die des fehlerhaften Batteriemoduls bzw. Strangs angepasst. Eine Reichweitenreduzierung wird damit minimiert und die Verfügbarkeit sowie die Zuverlässigkeit der Traktionsversorgung zum Erreichen beliebiger Safe-Stop-Levels werden somit ebenfalls erhöht. Des Weiteren kommt das erfindungsgemäß vorgeschlagene Verfahren lediglich im Fehlerfall zum Einsatz, wodurch die Auslastung der Batteriesteuereinheit des Batteriesystems minimiert wird.

Mittels des erfindungsgemäß vorgeschlagenen Verfahrens sind auch Mehrfachfehler innerhalb eines Batteriemoduls bzw. eines Strangs oder Mehrfachfehler batteriemodul- bzw. strangübergreifend abbildbar.

Außerdem ist das erfindungsgemäß vorgeschlagene Verfahren fehlerunabhängig und somit für Zellenfehler oder Elektronikfehler anwendbar. Darüber hinaus kann das erfindungsgemäß vorgeschlagene Verfahren auch für Batteriesysteme mit Kopplungseinrichtungen nicht nur für einzelne Batteriezellen, sondern auch für Batteriemodule eingesetzt werden.

### Kurze Beschreibung der Zeichnungen

Ausführungsformen der Erfindung werden anhand der Zeichnungen und der nachfolgenden Beschreibung näher erläutert.

Es zeigen:
- Figur 1: einen Aufbau eines viersträngigen Batteriesystems mit parallel und seriell verschalteten Batteriezellen,
- Figur 2: einen Aufbau eines dreisträngigen Batteriesystems in 1p-Anordnung,
- Figur 3: ein elektrisches Antriebssystem mit einem dreisträngigen Batteriesystem in 1p-Anordnung, mit Batteriezellenkopplungseinrichtungen,
- Figur 4: ein Batteriemodul mit seriell geschalteten Batteriezellen in 3p-Anordnung mit Batteriezellenkopplungseinrichtung
- Figur 5: ein Batteriemodul in 1p-Anordnung mit diesem zugeordneten Kopplungseinrichtungen in Haupt- und Umgehungsleitung,
- Figur 6: ein Batteriemodul in 3p-Anordnung mit diesem zugeordneten Kopplungseinrichtungen in Haupt- und Umgehungsleitung und
- Figur 7: ein schematischer Verfahrensablauf des erfindungsgemäß vorgeschlagenen Verfahrens zum Betreiben eines fehlertoleranten Batteriesystems.

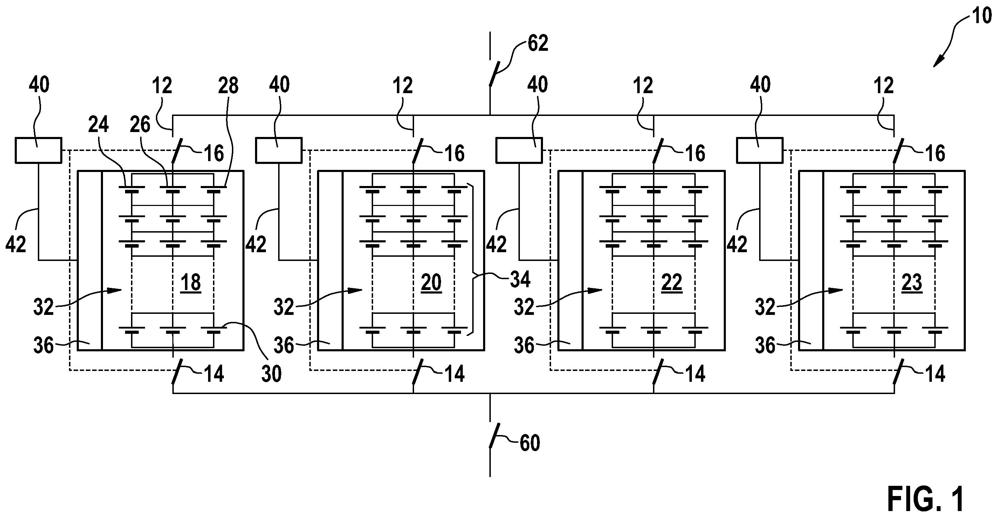

Figur 1 zeigt einen Aufbau eines Batteriesystems 10 mit vier Strängen 12, die jeweils ein Batteriemodul 18, 20, 22, 23, einen ersten Strangschütz 14 und einen zweiten Strangschütz 16 umfassen. Aus der Darstellung gemäß Figur 1 geht hervor, dass einem jeden der Batteriemodule 18, 20, 22, 23 eine Batteriezellenüberwachungseinheit 36 zugeordnet ist. Die Batteriemodule 18, 20, 22, 23 sind derart aufgebaut, dass in diesen die Batteriezellen 24, 26, 28, 30 in einer 12s3p-Schaltung 32 miteinander verschaltet sind. Das Batteriesystem 10 gemäß der Darstellung in Figur 1 umfasst vier Batteriesteuereinheiten 40, die jeweils sowohl mit dem ersten Strangschütz 14 als auch mit dem zweiten Strangschütz 16 in Verbindung steht und auch mit den Batteriezellenüberwachungseinheit 36 der einzelnen Batteriemodule 18, 20, 22, 23 via eine Kommunikationsleitung 42, wie beispielsweise einen CAN-Bus, kommuniziert. Das Batteriesystem 10 gemäß der Darstellung in Figur 1 umfasst ferner einen ersten Hauptschütz 60 und einen zweiten Hauptschütz 62 zum Zu- und Abschalten des Batteriesystems 10.

Bei dem in Figur 1 dargestellten Batteriesystem 10 bilden üblicherweise zehn bis zwölf Batteriezellen 24, 26, 28, 30 ein Batteriemodul 18, 20, 22, 23. Sind mehrere solcher Batteriemodule 18, 20, 22, 23 so zum Beispiel acht bis zehn Batteriemodule, seriell miteinander verschaltet, wird die erforderliche Batteriespannung von beispielsweise 400 V erreicht.

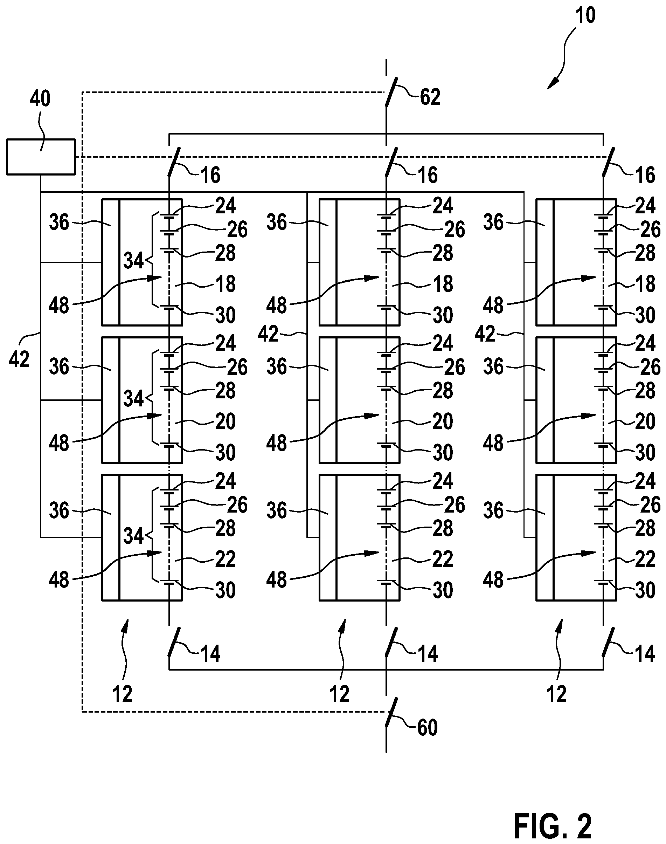

Aus der Darstellung gemäß Figur 2 geht hervor, dass das Batteriesystem 10 drei Stränge 12 umfasst. Innerhalb eines jeden der Stränge 12, der über einen ersten Strangschütz 14 und einen zweiten Strangschütz 16 abgesichert ist, befinden sich ein erstes Batteriemodul 18, ein zweites Batteriemodul 20 sowie ein drittes Batteriemodul 22, wobei die Batteriemodule 18, 20. 22 seriell miteinander verschaltet sind. Wie aus der Darstellung gemäß Figur 2 des Weiteren hervorgeht, sind innerhalb der einzelnen Batteriemodule 18, 20, 22 die Batteriezellen 24, 26, 28, 30 im Rahmen einer Serienschaltung 34 verschaltet. Die in Figur 2 dargestellte Darstellung wird auch als 1p-Anordnung 48 bezeichnet. Einem jeden der Batteriemodule 18, 20, 22 gemäß der Darstellung in Figur 2 sind eine Batteriezellenüberwachungseinheit 36 mit hier nicht dargestellten Sensoren zugeordnet. Das Batteriesystem 10 weist ferner eine Batteriesteuereinheit 40 auf, die via eine Kommunikationsleitung 42 mit den Batteriezellenüberwachungseinheiten 36 kommuniziert.

Anstelle der in Figur 2 dargestellten 1p-Anordnung 48 können die einzelnen Batteriemodule 18, 20, 22 auch in einer 2p-Anordnung oder einer 3p-Anordnung 50, vgl. Darstellung gemäß Figur 1, aufgebaut sein. Alle Batteriemodule 18, 20, 22 gemäß der Darstellung in Figur 2 weisen einen identischen Aufbau auf.

Die in Figuren 1 und 2 dargestellten Batteriesysteme 10 sind nur insofern fehlertolerant, als dass im Fehlerfall ein Batteriemodul 18, 20, 22, 23 bzw. Strang 12 abgeschaltet wird, was mit einer Kapazitätsreduzierung und somit einer Leistungsreduzierung einhergeht.

### Ausführungsformen der Erfindung

In der nachfolgenden Beschreibung der Ausführungsformen der Erfindung werden gleiche oder ähnliche Elemente mit gleichen Bezugszeichen bezeichnet, wobei auf eine wiederholte Beschreibung dieser Elemente in Einzelfällen verzichtet wird. Die Figuren stellen den Gegenstand der Erfindung nur schematisch dar.

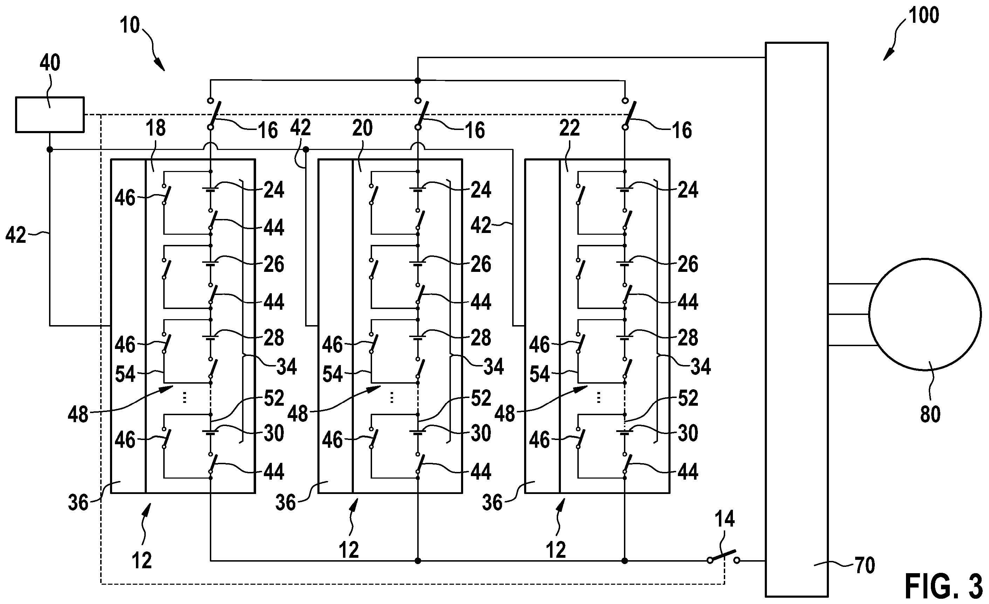

Figur 3 zeigt ein elektrisches Antriebssystem 100. Das elektrische Antriebssystem 100 umfasst ein dreisträngiges Batteriesystem 10, einen Elektromotor 80. Dabei ist das Batteriesystem 10 sowie einen Wechselrichter 70, der mit dem Elektromotor 80 verbunden ist.

Aus der Darstellung gemäß Figur 3 geht hervor, dass die Stränge 12 jeweils ein Batteriemodul 18, 20, 22 umfassen. Dabei umfasst der erste Strang 12 das erste Batteriemodul 18, der zweite Strang 12 das zweite Batteriemodul 20 und der dritte Strang 12 das dritte Batteriemodul 22. Die drei Batteriemodule 18, 20, 22 des Batteriesystems 10 umfassen jeweils eine Batteriezellenüberwachungseinheit 36. In jedem Batteriemodul 18, 20, 22 sind die Batteriezellen 24, 26, 28, 30 in Serienschaltung 34 verschaltet. Im Unterschied zur Ausgestaltung der ebenfalls in Serienschaltung 34 geschalteten Batteriemodule 18, 20, 22 gemäß Figur 2, sind bei dem in Figur 3 dargestellten Batteriemodul 18, 20, 22 im Batteriesystem 10 einer Hauptleitung 52 des Strangs 12 erste Kopplungseinrichtungen 44 vorgesehen. Einer jeden der in den Batteriemodulen 18, 20, 22 gemäß der Ausführungsvariante in Figur 3 dargestellten Batteriezelle 24, 26, 28, 30 ist eine Umgehungsleitung 54 zugeordnet, in der sich jeweils eine zweite Kopplungseinrichtung 46 befindet.

Fällt eine der Batteriezellen 24, 26, 28, 30 der Batteriemodule 18, 20, 22 gemäß Figur 3 aus, wird die dieser Batteriezelle 24, 26, 28, 30 jeweils zugeordnete erste Kopplungseinrichtung 44 geöffnet, sodass die betreffende Batteriezelle 24, 26, 28, 30 abgeschaltet werden kann. Eine Umgehung erfolgt durch ein jeweiliges Schließen der zweiten Kopplungseinrichtung 46 in der der abzuschaltenden Batteriezelle 24, 26, 28, 30 jeweils zugeordneten Umgehungsleitung 54.

Der Vollständigkeit halber sei erwähnt, dass in den Batteriemodulen 18, 20, 22 des Batteriesystems 10 gemäß Figur 3 die Batteriezellen 24, 26, 28, 30 in 1p-Anordnung 48 geschaltet sind.

Den Stränge 12 des Batteriesystems 10 ist ein gemeinsamer erster Strangschütz 14 zugeordnet. Zum Abschalten der Stränge 12 unabhängig voneinander, umfassen die Stränge 12 jeweils einen zweiten Strangschütz 16.

Anstelle die defekte Batteriezelle 24, 26, 28, 30 aus dem Batteriemodul 18, 20, 22 zu überbrücken und zwecks Spannungsangleichung weitere intakte Batteriezellen 24, 26, 28, 30 aus den restlichen Batteriemodulen 18, 20, 22 bzw. Strängen 12 zu überbrücken, was mit einer Spannungsreduzierung und letztendlich mit einer Reichweitenreduzierung einhergeht, wird hier durch Betätigen des zweiten Strangschützes 16 des Batteriemoduls 18, 20, 22 bzw. des Strangs 12 mit der defekten Batteriezelle 24, 26, 28, 30, eine Spannungsangleichung vorgenommen.

Zur Veranschaulichung des erfindungsgemäß vorgeschlagenen Verfahrens wird hierbei angenommen, dass bei der ersten Batteriezelle 24 des ersten Batteriemoduls 18 ein Fehler vorliegt. Selbstverständlich können Fehler bei einer anderen oder mehreren Batteriezellen 24, 26, 28, 30 eines Batteriemoduls 18, 20, 22 oder verschiedener Batteriemodule 18, 20, 22 vorliegen.

Erkennt die Batteriesteuereinheit 40, in dem ein
Batteriesystemmanagementsystem implementiert ist, einen Fehler der ersten Batteriezelle 24 des ersten Batteriemoduls 18, sei es ein Zellenfehler, sei es ein Elektronikfehler, so werden die erste und die zweite Kopplungseinrichtung 44, 46 des ersten Batteriezelle 24 des ersten Batteriemoduls 18 betätigt, um diese dauerhaft zu überbrücken. Gleichzeitig schaltet der zweite Strangschütz 16 des ersten Strangs 12 um und trennt den ersten Strang 12 von den beiden anderen Stränge 12 ab, da eine Spannungsdifferenz zwischen den Batteriemodulen 18, 20, 22 bzw. den Strängen 12 besteht, welche zu hohen Ausgleichströmen führen würde, wodurch die Batteriezellen 24, 26, 28, 30 geschädigt werden und somit schneller altern.

Da die Strangschütze 14, 16 nicht unter hoher Last betrieben werden sollten, ist darauf zu achten, dass im Abschaltzeitpunkt der Strom nicht zu groß, beispielsweise kleiner als 20 A, ist. Beim Ladevorgang kann dies problemlos in der Ladestrategie berücksichtigt werden. Anders sieht es während der Fahrt, also im Entladevorgang aus; hier sollte kein abrupter Leistungseinbruch erfolgen. Eine Fehlerarterkennung eines sicherheitskritischen Zellenfehlers oder eines weniger kritischen Elektronikfehlers führt dazu, dass im letztgenannten Fall ein Herauszögern der Abschaltung ermöglicht werden kann, bis die Strombedingung erfüllt ist, wie bspw. im Stand an einer Ampel oder im Segelbetrieb, wenn keine Momentenanforderung vorliegt. Ein sicherheitskritischer Zellenfehler muss allerdings umgehend nach seiner Erkennung zu einer Abschaltung führen. Der Fahrer kann dabei durch einen Hinweis im Cockpit über einen möglichen unmittelbar bevorstehenden Leistungseinbruch informiert werden. Das Batteriemanagementsystem wird der Leistungsreduzierung weitestgehend entgegenwirken, indem es den geforderten Strom auf die beiden intakten Stränge 12, hier der zweite und dritte Strang 12 bzw. Batteriemodul 20, 22, aufteilt und somit werden die Batteriezellen 24, 26, 28, 30 des zweiten und dritten Strangs 12 bzw. Batteriemodule 20, 22 mit höheren Strangströmen in den Grenzen der Zulässigkeit beaufschlagt. Somit spürt der Fahrer lediglich im Volllastbetrieb, also bei maximaler Momentenanforderung, einen Leistungseinbruch.

Der zweite Strangschütz 16 des ersten Strangs 12 bleibt nur solange geöffnet, bis sich die Spannungen des ersten und des zweiten Strangs 12 nahezu, beispielsweise bis auf ca. 1 V bis 2 V, auf das Niveau des ersten Strangs 12 angeglichen haben. Während dieser Zeit stellen der zweite und der dritte Strang 12 die Energie für das Elektrofahrzeug zur Verfügung und liefern, soweit möglich, entsprechend höhere Strangströme. Findet in dieser Phase ein Rekuperationsvorgang statt, so schließt der zweite Strangschütz 16 des ersten Strangs 12 und die intakten Batteriezellen26, 28, 30 des ersten Batteriemoduls 18 werden solange aufgeladen, bis eine Spannungsangleichung erfolgt ist, während die zweiten Strangschütze 16 des zweiten und dritten Strangs 12 geöffnet sind. Danach werden die Batteriezellen 24, 26, 28, 30 aller drei Stränge 12 aufgeladen.

Auf gleichem Spannungsniveau stehen wieder alle drei Stränge 12 zur Verfügung und können somit ihre maximale Leistung liefern, bis eine Entladeschlussspannung erreicht ist. Der Energieverlust, welcher sich letztendlich auf die Reichweite des Elektrofahrzeugs niederschlägt, ergibt sich lediglich aus der Dauer der Spannungsanpassungsphase und dem Entladestrom. Dies führt vorteilhafter Weise dazu, dass die Verfügbarkeit und Zuverlässigkeit der Traktionsversorgung gesteigert wird. Dadurch lassen sich beliebige Safe-Stop-Levels erreichen.

Die Fahrt kann somit ohne Einschränkungen fortgeführt werden; eine Reparatur kann danach erfolgen. Findet kein Batteriezellen- oder Batteriemodultausch statt und wird die Batterie des Elektrofahrzeugs geladen, so kann entweder bei Erreichen der, um die eine Zellspannung reduzierte Strangspannung, der Ladevorgang beendet werden. Alternativ lassen sich durch Öffnen des zweiten Strangschützes 16 des ersten Strangs 12 auch noch die beiden intakten Stränge 12 vollständig aufladen. Der Entladevorgang erfolgt in diesem Fall, wie oben beschrieben mit dem geöffneten zweiten Strangschütz 16 des ersten Strangs 12 solange, bis sich die Spannungen der drei Stränge 12 auf gleichem Niveau befinden.

Vorteilhaft bei diesem Aufbau ist, dass auch mehrere Fehler in einem Batteriemodul 18, 20, 22 bzw. einem Strang 12, sogenannte Doppelfehler oder Mehrfachfehler, behandelt werden können. Auch Fehler in unterschiedlichen Strängen 12 können mit dem erfindungsgemäß vorgeschlagenen Verfahren abgebildet werden. Das erfindungsgemäß vorgeschlagene Verfahren bietet den Vorteil, dass keine weiteren Batteriezellen 24, 26, 28, 30, außer der fehlerhaften Batteriezelle 24, 26, 28, 30, abgeschaltet werden müssen, was mit einer geringeren Reichweitenreduzierung einhergeht. Somit ist das Betreiben des Batteriesystems 10 im Fehlerfall ohne zusätzliche Hardware bei gleichzeitiger maximal möglicher Kapazität sichergestellt.

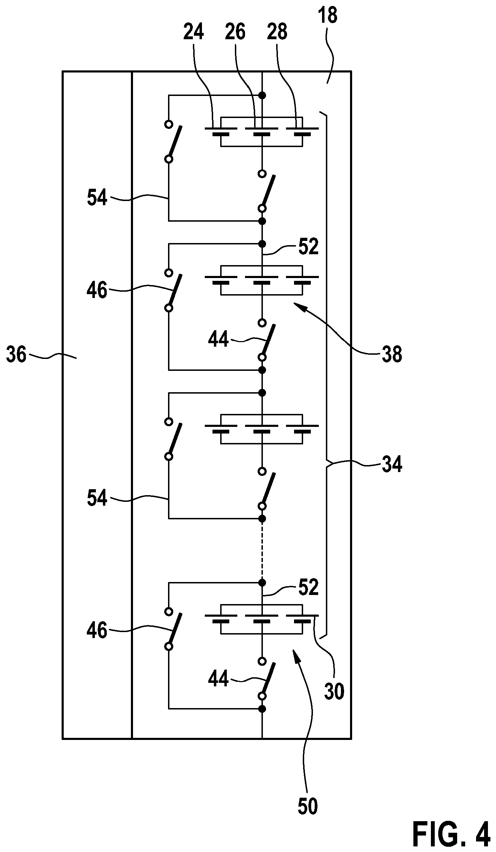

Figur 4 zeigt das erste Batteriemodul 18 des fehlertoleranten Batteriesystems 10 mit ersten und zweiten Kopplungseinrichtungen 44, 46, die in 3p-Anordnung 50 verschalteten Batteriezellen 24, 26, 28, 30 zugeordnet sind.

In Figur 4 ist das erste Batteriemodul 18 derart aufgebaut, dass einzelne zu 3p-Batteriezellenpaketen 38 verschaltete Batteriezellen 24, 26, 28, 30 in Serienschaltung 34 geschaltet sind, beispielsweise zwölf Batteriezellenpakete 38. Das erste Batteriemodul 18 gemäß Figur 4 ist derart aufgebaut, dass vor einer jeden 3p-Anordnung 50 bzw. einem jeden Batteriezellenpaket 38 der einzelnen Batteriezellen 24, 26, 28, 30 die erste Kopplungseinrichtung 44 in der Hauptleitung 52 liegt. Vor dieser zweigt die Umgehungsleitung 54 ab, in der die zweite Kopplungseinrichtung 46 aufgenommen ist.

Durch die Ausführungsvariante des ersten Batteriemoduls 18 gemäß der Darstellung in Figur 4 ist ein Weiterbetrieb des ersten Batteriemoduls 18 auch dann möglich, wenn einzelne, in 3p-Anordnung 50 bzw. Batteriezellenpaket 38 verschaltete Batteriezellen 24, 26, 28, 30 ausfallen sollten, sodass ein Weiterbetrieb des ersten Batteriemoduls 18 durch Öffnen beziehungsweise Schließen der ersten und zweiten Kopplungseinrichtung 44, 46, d. h. durch Umgehen der schadhaften Batteriezelle 24, 26, 28, 30, möglich ist.

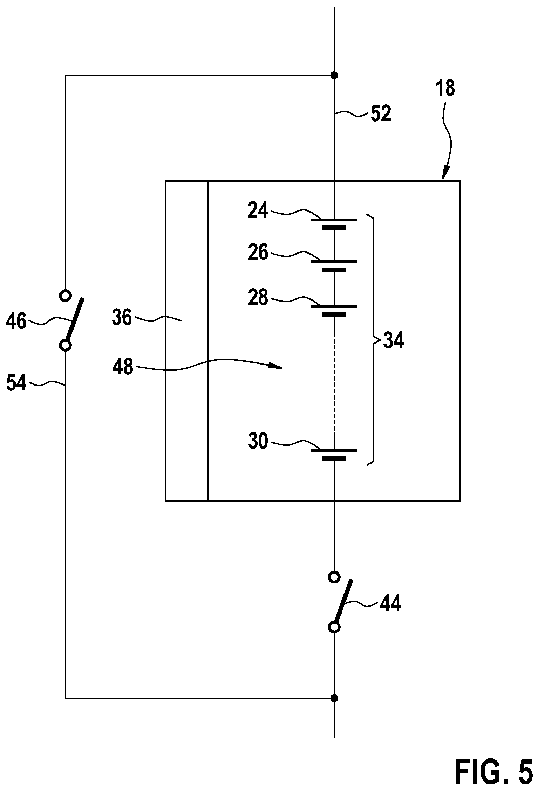

Figur 5 zeigt das erste Batteriemodul 18 in 1p-Anordnung 48 mit diesem zugeordneten Kopplungseinrichtungen 44, 46 in Haupt- und Umgehungsleitung 52, 54.

Aus der Darstellung gemäß Figur 5 geht ein fehlertolerantes Batteriesystem 10 hervor, dessen hier beispielhaft herausgegriffenes erstes Batteriemodul 18 in Serienschaltung 34 miteinander verschaltete Batteriezellen 24, 26, 28, 30 umfasst. Das erste Batteriemodul 18 zeigt die Master- sowie die Slave-Batteriezellenüberwachungseinheiten 36, die jeweils mit den in Serienschaltung 34 miteinander verschalteten Batteriezellen 24, 26, 28, 30 verbunden sind.

Wie aus Figur 5 weiter hervorgeht, befindet sich in der Hauptleitung 52 die erste Kopplungseinrichtung 44, vor der, analog zur Ausführungsvariante gemäß Figur 4, die Umgehungsleitung 54 abzweigt. In dieser ist die zweite Kopplungseinrichtung 46 angeordnet. Zum Abschalten des ersten Batteriemoduls 18 aus der Hauptleitung 52 erfolgt ein Öffnen der ersten Kopplungseinrichtung 44 und ein Schließen der zweiten Kopplungseinrichtung 46, sodass ein sich beispielsweise als schadhaft herausgestellt habendes erstes Batteriemodul 18 über die Umgehungsleitung 54 innerhalb des Strangs 12 des Batteriesystems 10 umgangen werden kann und ein Weiterbetrieb des erfindungsgemäß vorgeschlagenen fehlertoleranten Batteriesystems 10 möglich ist.

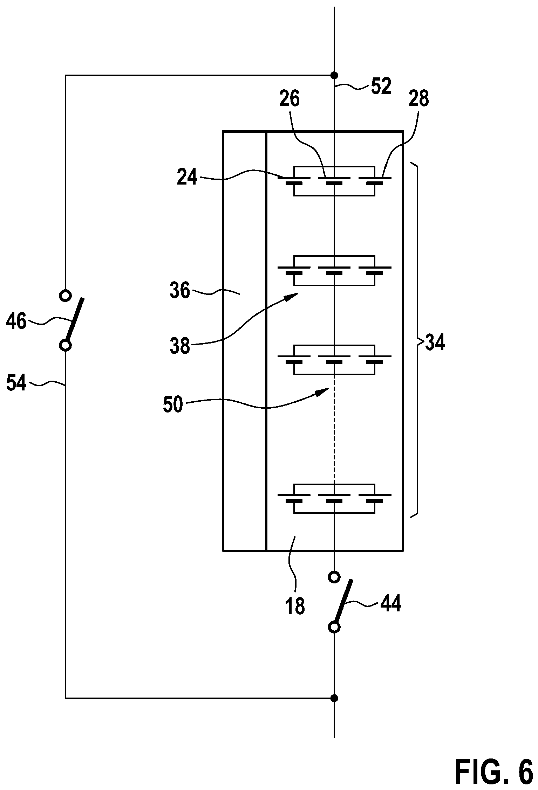

Figur 6 zeigt das erste Batteriemodul 18 in 3p-Anordnung 50, dem eine erste und eine zweite Kopplungseinrichtung 44, 46 zugeordnet ist.

Aus Figur 6 geht hervor, dass das dort dargestellte erste Batteriemodul 18 eine Anzahl von Batteriezellen 24, 26, 28, 30 aufweist, die jeweils in 3p-Anordnung 50 bzw. Batteriezellenpaket 38 parallel geschaltet sind. Das in Figur 6 herausgegriffene erste Batteriemodul 18 des Batteriesystems 10 weist in der Hauptleitung 52 eine erste Kopplungseinrichtung 44 auf. Vor der ersten Kopplungseinrichtung 44 zweigt die Umgehungsleitung 54 ab, in der die zweite Kopplungseinrichtung 46 aufgenommen ist. Fällt das Batteriesystem 10, dessen in 3p-Anordnung 50 verschaltete Batteriezellen 24, 26, 28, 30 in Serienschaltung 34 geschaltet sind, aus, so wird die erste Kopplungseinrichtung 44 geöffnet, die in der Umgehungsleitung 54 liegende zweite Kopplungseinrichtung 46 geschlossen und mithin das schadhafte Batteriemodul überbrückt, sodass im Batteriesystem 10 nur das schadhafte der Batteriemodule 18, 20, 22 abgeschaltet ist und das Batteriesystem 10 weiter betrieben werden kann, wenn auch mit verminderter Leistung. Dadurch ist gewährleistet, dass über das fehlertolerant ausgestaltete Batteriesystem 10 gemäß der vorliegenden Erfindung ein Weiterbetrieb des autonom fahrenden elektrischen Fahrzeugs gewährleistet ist, die Fahrt nicht unterbrochen zu werden braucht, sondern, wenn auch mit verminderter Leistung und erhöhter Dauer, fortgesetzt werden kann.

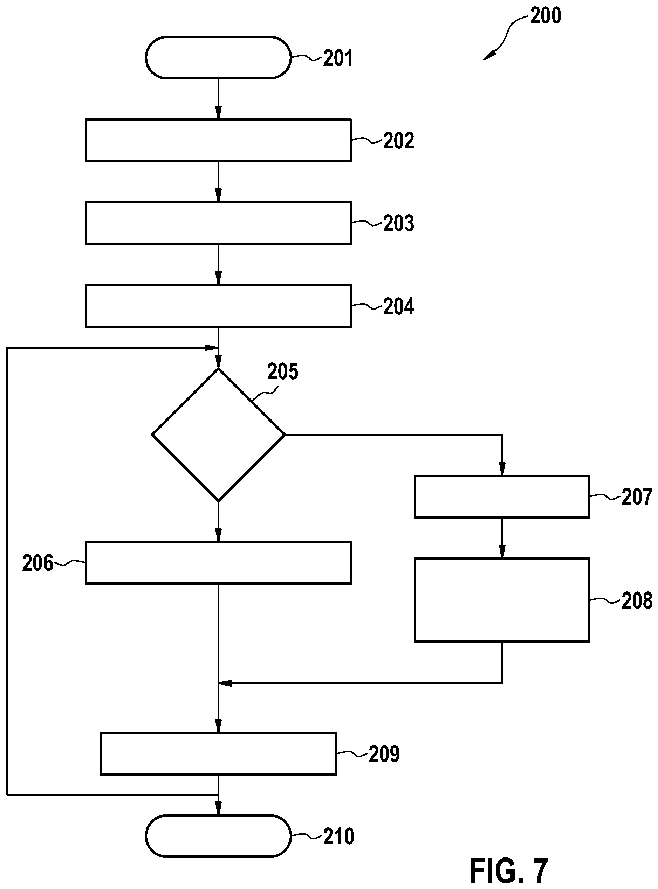

Figur 7 zeigt ein schematischer Verfahrensablauf 200 des erfindungsgemäß vorgeschlagenen Verfahrens zum Betreiben eines fehlertoleranten Batteriesystems 10.

Aus Figur 7 ist zu entnehmen, dass ausgehend von einem Start in einem Verfahrensschritt 201 das erfindungsgemäß vorgeschlagene Verfahren durchzulaufen beginnt.

Zunächst wird ein Fehler einer Batteriezelle 24, 26, 28, 30 in einem Verfahrensschritt 202 erkannt. Dies kann durch Auswertung der Messwerte der Batteriezellen 24, 26, 28, 30 erfolgen.

Anschließend wird in einem Verfahrensschritt 203 die fehlerhafte Batteriezelle 24, 26, 28, 30 oder des fehlerhaften Batteriezellenpakets 38, in dem sich die fehlerhafte Batteriezelle 24, 26, 28, 30 befindet, abgeschaltet und überbrückt. Die fehlerhafte Batteriezelle 24, 26, 28, 30 oder das fehlerhafte Batteriezellenpaket 38 bleibt dabei dauerhaft überbrückt.

Gleichzeitig wird in einem Verfahrensschritt 204 der fehlerhafte Strang 12 abgeschaltet, der die fehlerhafte Batteriezelle 24, 26, 28, 30 oder das fehlerhafte Batteriezellenpaket 38 aufweist.

Anschließend wird in einem Verfahrensschritt 205 die Strangspannung des fehlerhaften Strangs 12 mit der Strangspannung der jeweiligen intakten Stränge 12, bei denen keine Fehler erkannt wurden, verglichen.

Wenn Spannungsdifferenzen zwischen den Strängen 12 einen Spannungsschwellenwert überschreiten, werden die intakten Stränge12 in einem Verfahrensschritt 206 entladen. Der fehlerhafte Strang 12 bleibt nur solange abgeschaltet, bis sich die Strangspannungen der intakten Stränge 12 nahezu auf das Niveau des fehlerhaften Strangs 12 angeglichen haben. Dabei stellen die intakten Stränge 12die Energie für das Elektrofahrzeug zur Verfügung und liefern entsprechend höhere Strangströme. Wenn während des Entladens der intakten Stränge 12 ein Rekuperationsvorgang stattfindet, wird der fehlerhafte Strang 12 zugeschaltet. Die intakten Batteriezellen 24, 26, 28, 30 des fehlerhaften Strangs 12 werden dabei durch den Rekuperationsstrom solange aufgeladen, bis eine Spannungsangleichung der Stränge 12 erfolgt ist. Danach werden die intakten Batteriezellen 24, 26, 28, 30 aller Stränge 12 aufgeladen.

Wenn Spannungsdifferenzen zwischen den Strängen 12 den Spannungsschwellenwert unterschreiten, wird der fehlerhafte Strang 12 in einem Verfahrensschritt 207 zugeschaltet. Danach werden die Batteriezellen 24, 26, 28, 30 aller Stränge 12 in einem Verfahrensschritt 208 entladen. Wenn hierbei ein Rekuperationsvorgang stattfindet, werden ebenfalls die Batteriezellen 24, 26, 28, 30 aller Stränge 12 aufgeladen.

Auf gleichem Spannungsniveau stehen in einem Verfahrensschritt 209 wieder alle Stränge 12 zur Verfügung und können somit ihre maximale Leistung liefern bis eine Entladeschlussspannung erreicht ist und das erfindungsgemäß vorgeschlagene Verfahren wird in einem Verfahrensschritt 210 beendet, wenn das Batteriesystem 10 abgeschaltet wird.

Die Erfindung ist nicht auf die hier beschriebenen Ausführungsbeispiele und die darin hervorgehobenen Aspekte beschränkt. Vielmehr ist innerhalb des durch die Ansprüche angegebenen Bereichs eine Vielzahl von Abwandlungen möglich, die im Rahmen fachmännischen Handelns liegen.

## Patentansprüche

1. Verfahren zum Betreiben eines Batteriesystems (10), welches mehrere parallel zueinander geschaltete Stränge (12) umfasst, die jeweils mindestens ein Batteriemodul (18, 20, 22, 23) aufweisen, in dem mehrere Batteriezellen (24, 26, 28, 30) in Serienschaltung (34) und/oder in Parallelschaltung verschaltet sind, wobei
die Stränge (12) voneinander zu- und abschaltbar sind, und wobei einzelne Batteriezellen (24, 26, 28, 30) und/oder einzelne Batteriezellenpakete (38), die jeweils mehrere parallel verschaltete Batteriezellen (24, 26, 28, 30) umfassen, voneinander zu- und abschaltbar und überbrückbar sind,
umfassend zumindest nachfolgende Verfahrensschritte:
- Erkennen eines Fehlers einer Batteriezelle (24, 26, 28, 30);
- Abschalten und Überbrücken der fehlerhaften Batteriezelle (24, 26, 28, 30) und/oder des fehlerhafte Batteriezellenpakets (38), in dem sich die fehlerhafte Batteriezelle (24, 26, 28, 30) befindet;
- Abschalten des fehlerhaften Strangs (12), der die fehlerhafte Batteriezelle (24, 26, 28, 30) und/oder das fehlerhafte Batteriezellenpacket (38) aufweist;
- Vergleichen der Strangspannung des fehlerhaften Strangs (12) mit der Strangspannung der jeweiligen intakten Stränge (12), bei denen keine Fehler erkannt wurden;
- Entladen der intakten Stränge (12), wenn Spannungsdifferenzen zwischen den intakten Strängen (12) einen Spannungsschwellenwert überschreiten,
- Zuschalten des fehlerhaften Strangs (12), wenn sich die Strangspannungen der jeweiligen intakten Stränge (12) nahezu auf das Niveau der Strangspannung des fehlerhaften Strangs (12) angeglichen haben, oder wenn während des Entladens der intakten Stränge (12) ein Rekuperationsvorgang stattfindet.

2. Verfahren nach Anspruch 1, **dadurch gekennzeichnet, dass** der fehlerhafte Strang (12) zugeschaltet wird, wenn Spannungsdifferenzen zwischen den Strängen (12) den Spannungsschwellenwert unterschreiten.

3. Verfahren nach Anspruch 1 oder 2, **dadurch gekennzeichnet, dass** der Spannungsschwellenwert in einem Bereich von 1 V bis 2 V liegt.

4. Verfahren nach einem der Ansprüche 1 bis 3, **dadurch gekennzeichnet, dass**
beim Laden des Batteriesystems (10) alle Stränge (12) aufgeladen werden, wobei ein Ladevorgang beim Erreichen einer um eine oder mehrere Zellenspannungen reduzierte Strangspannung beendet wird.

5. Verfahren nach einem der Ansprüche 1 bis 3, **dadurch gekennzeichnet, dass**
beim Laden des Batteriesystems (10) die intakten Stränge (12) vollständig aufgeladen werden, wobei nach dem Laden ein Entladevorgang der intakten Stränge (12) erfolgt, bis sich die Strangspannungen aller Stränge (12) auf gleichem Niveau befinden.

6. Verfahren nach einem der Ansprüche 1 bis 5, **dadurch gekennzeichnet, dass**
der fehlerhafte Strang (12) beim Erkennen von Elektronikfehlern erst abgeschaltet wird, wenn ein Strangstrom einen Stromschwellenwert unterschreitet.

7. Verfahren nach Anspruch 6, **dadurch gekennzeichnet, dass**
der Stromschwellenwert in einem Bereich von 15 A bis 25 A liegt.

8. Batteriesystem (10), das eingerichtet ist, ein Verfahren nach einem der Ansprüche 1 bis 7 durchzuführen.

9. Fahrzeug, das eingerichtet ist, ein Verfahren nach einem der Ansprüche 1 bis 7 durchzuführen und/oder das ein Batteriesystem (10) nach Anspruch 8 umfasst.

## Claims

1. Method for operating a battery system (10), which comprises a plurality of parallel connected strings (12), each having at least one battery module (18, 20, 22, 23), in which a plurality of battery cells (24, 26, 28, 30) are connected in a series circuit (34) and/or in a parallel circuit, wherein
the strings (12) can be switched on and off from one another, and wherein
individual battery cells (24, 26, 28, 30) and/or individual battery cell packs (38), each comprising a plurality of battery cells (24, 26, 28, 30) connected in parallel, can be switched on and off from one another and can be bypassed,
comprising at least the following method steps:
- detecting a fault in a battery cell (24, 26, 28, 30);
- switching off and bypassing the faulty battery cell (24, 26, 28, 30) and/or the faulty battery cell pack (38) in which the faulty battery cell (24, 26, 28, 30) is located;
- switching off the faulty string (12) which has the faulty battery cell (24, 26, 28, 30) and/or the faulty battery cell packet (38);
- comparing the string voltage of the faulty string (12) with the string voltage of the respective intact strings (12) in which no faults have been detected;
- discharging the intact strings (12) if voltage differences between the intact strings (12) exceed a voltage threshold value,
- switching on the faulty string (12), if the string voltages of the respective intact strings (12) have almost matched the level of the string voltage of the faulty string (12), or if a recuperation process takes place during the discharging of the intact strings (12).

2. Method according to Claim 1, **characterized in that**
the faulty string (12) is switched on if voltage differences between the strings (12) fall below the voltage threshold value.

3. Method according to Claim 1 or 2, **characterized in that**
the voltage threshold value lies within a range of 1 V to 2 V.

4. Method according to one of Claims 1 to 3, **characterized in that**
while the battery system (10) is being charged, all of the strings (12) are charged, with a charging process being terminated when a string voltage reduced by one or more cell voltages is reached.

5. Method according to one of Claims 1 to 3, **characterized in that**
while the battery system (10) is being charged, the intact strings (12) are fully charged, the charging being followed by a discharging process of the intact strings (12) until the string voltages of all of the strings (12) are at the same level.

6. Method according to one of Claims 1 to 5, **characterized in that**
when electronic faults are detected, the faulty string (12) is switched off only when a string current falls below a current threshold value.

7. Method according to Claim 6, **characterized in that**
the current threshold value lies in the range of 15 A to 25 A.

8. Battery system (10) which is configured to carry out a method according to one of Claims 1 to 7.

9. Vehicle which is designed to carry out a method according to one of Claims 1 to 7, and/or which comprises a battery system (10) according to Claim 8.

## Revendications

1. Procédé pour faire fonctionner un système de batterie (10) qui comprend plusieurs groupes (12) connectés en parallèle les uns aux autres, qui comprennent chacun au moins un module de batterie (18, 20, 22, 23), plusieurs cellules de batterie (24, 26, 28, 30) étant montées en série (34) et/ou en parallèle,
les groupes (12) étant aptes à être connectés entre eux et déconnectés les uns des autres, et
les cellules de batterie individuelles (24, 26, 28, 30) et/ou les blocs de cellules de batterie individuels (38), qui comprennent chacun plusieurs cellules de batterie (24, 26, 28, 30) montées en parallèle, sont aptes à être connectés et déconnectés les uns des autres et sont aptes à être pontés,
comprenant au moins les étapes suivantes :
- détection d'un défaut d'une cellule de batterie (24, 26, 28, 30) ;
- déconnexion et pontage de la cellule de batterie défectueuse (24, 26, 28, 30) et/ou du bloc de cellules de batterie défectueux (38) dans lequel se trouve la cellule de batterie défectueuse (24, 26, 28, 30) ;
- déconnexion du groupe défectueux (12) qui comprend la cellule de batterie défectueuse (24, 26, 28, 30) et/ou le bloc de cellules de batterie défectueux (38) ;
- comparaison de la tension de groupe du groupe défectueux (12) avec la tension de groupe des groupes intacts (12) respectifs dans lesquels aucun défaut n'a été détecté ;
- décharge des groupes intacts (12) lorsque les différences de tension entre les groupes intacts (12) dépassent une valeur seuil de tension,
- connexion du groupe défectueux (12) lorsque les tensions de groupe des groupes intacts respectifs (12) se sont pratiquement alignées sur le niveau de la tension de groupe du groupe défectueux (12) ou lorsqu'un processus de récupération a lieu pendant la décharge des groupes intacts (12).

2. Procédé selon la revendication 1, **caractérisé en ce que**
le groupe défectueux (12) est connecté lorsque les différences de tension entre les groupes (12) sont inférieures à la valeur seuil de tension.

3. Procédé selon la revendication 1 ou la revendication 2, **caractérisé en ce que**
la valeur seuil de tension se situe dans une gamme allant de 1V à 2V.

4. Procédé selon l'une des revendications 1 à 3, **caractérisé en ce que**
lors du chargement du système de batterie (10), tous les groupes (12) sont chargés, un processus de chargement étant interrompu lorsqu'une tension de groupe réduite d'une ou plusieurs tensions de cellule est atteinte.

5. Procédé selon l'une des revendications 1 à 3, **caractérisé en ce que**
lors de la charge du système de batterie (10), les groupes (12) intacts sont complètement chargés, un processus de décharge des groupes (12) intacts ayant lieu après la charge jusqu'à ce que les tensions de groupe de tous les groupes (12) se trouvent au même niveau.

6. Procédé selon l'une des revendications 1 à 5, **caractérisé en ce que**
le groupe défectueux (12) n'est déconnecté lors de la détection de défauts électroniques que lorsqu'un courant de groupe passe en dessous d'une valeur seuil de courant.

7. Procédé selon la revendication 6, **caractérisé en ce que**
la valeur seuil de courant se situe dans une gamme allant de 15A à 25A.

8. Système de batterie (10) qui est conçu pour mettre en œuvre un procédé selon l'une des revendications 1 à 7.

9. Véhicule qui est conçu pour mettre en œuvre un procédé selon l'une des revendications 1 à 7 et/ou qui comprend un système de batterie (10) selon la revendication 8.
